# EUROPEAN PATENT APPLICATION

(11) **EP 4 518 137 A1**
(43) Date of publication of application: **05.03.2025**
(21) Application number: 23819263.7
(22) Date of filing: 09.06.2023
(51) Int. Cl.: H02M 7/483, H02M 7/5387, H02M 1/32, H02M 1/44, H02M 1/088

(54) **TOPOLOGICAL CIRCUIT SYSTEM FOR HYBRID DEVICE DRIVE MOTOR**

(30) Priority: 10.06.2022 CN 202210655297
(71) Applicant: Xeca Turbo Clean Power Rugao Co., Ltd., Rugao Nantong, Jiangsu 226000 (CN)
(72) Inventor: ZHANG, Xuefeng, Nantong, Jiangsu 226000 (CN); BAI, Jiangtao, Nantong, Jiangsu 226000 (CN)
(74) Representative: Murgitroyd & Company
(86) International application number: PCT/CN2023/099421
(87) International publication number: WO 2023/237100

(57) **Abstract**

The present application relates to the field of motor drive technologies, and in particular, to a topology circuit system of a hybrid device-based driving motor, which includes: a motor, a three-level topology circuit and a driving circuit. The three-level topology circuit includes a first full-bridge arm, a second full-bridge arm and a third full-bridge arm, each of the full-bridge arms is provided with a first switch device to a fourth switch device, and each of the switch devices is connected to resonant soft switching circuits. Two input ends of each of the resonant soft switching circuits are connected to an output end OUT_H and an output end OUT_L of respective one in the driving circuits, respectively. In the present invention, each of the switch devices of the three-level topology circuit is connected to a resonant soft switching circuit, and each resonant soft switching circuit is driven by a corresponding driving circuit. The resonant soft switching circuit absorbs or releases spike pulse of each of the switch devices in the three-level topology circuit through a common mode suppression method, so that t a buffering effect is played on the spike pulse of the switch device. A sudden change of the spike pulse is blocked by the inductor L1, the inductor L2 and the inductor L5, so that anti-interference capability of the driving circuit is effectively enhanced.

## Description

### CROSS-REFERENCE TO RELATED APPLICATIONS

The present application claims priority to Chinese Patent Application No. 202210655297.X, filed on June 10, 2022, and the contents of the aforementioned are hereby incorporated by reference in their entireties.

### TECHNICAL FIELD

The present invention relates to the field of motor drive technologies, and in particular, to a topology circuit system of a hybrid device-based driving motor.

### BACKGROUND

With the technical breakthrough of the third-generation SiC/GaN semiconductor devices, Si devices are gradually replaced by the SiC/GaN devices in the field of high-end drivers. The SiC/GaN devices have characteristics of high switching frequency and low switching loss, which may significantly improve performance of a motor driver. Under the background of promoting carbon neutrality and peak carbon dioxide emissions, requirements for energy efficiency are becoming more and more stringent. An electrical topology structure for the high-end motor drivers gradually changes from a two-level structure to a multi-level structure, to improve driving efficiency of the motor.

### SUMMARY

A purpose of the present invention is to provide a topology circuit system of a hybrid device-based driving motor to solve the above-mentioned problem.

In order to solve the above-mentioned technical problem, the invention provides a topology circuit system of a hybrid device-based driving motor, which includes a motor, a three-level topology circuit and a driving circuit. The three-level topology circuit includes a first full-bridge arm, a second full-bridge arm and a third full-bridge arm, each of the full-bridge arms is provided with a first switch device, a second switch device, a third switch device and a fourth switch device, and each of the switch devices is connected to resonant soft switching circuits. Two input ends of each of the resonant soft switching circuits are connected to an output end OUT_H and an output end OUT_L of respective one in the driving circuits, respectively. A quantity of the driving circuits is the same as a quantity of the resonant soft switching circuits, and the driving circuits and the resonant soft switching circuits are disposed correspondingly to each other.

A filter circuit is disposed between the motor and the three-level topology circuit.

Further, each of the resonant soft switching circuits includes a diode D1, an inductor L1, a third resistor R3, a capacitor C1, an inductor L2, a first resistor R1 and a second resistor R2. The diode D1 and the inductor L1 are connected in series between the output end OUT_H of the driving circuit and a gate of the switch device. The third resistor R3, the capacitor C1 and the inductor L2 are connected in series between the output end OUT_L of the driving circuit and a source of the switch device. The first resistor R1 and the second resistor R2 are connected in series, after connected in series, the other end of the first resistor R1 is connected to a negative electrode of the diode D1, and the other end of the second resistor R2 is disposed between the capacitor C1 and the inductor L2. A positive electrode of the diode D1 is connected to a node between the first resistor R1 and the second resistor R2, and the node between the first resistor R1 and the second resistor R2 is connected to a node between the third resistor R3 and the capacitor C1.

Further, the filter circuit includes a capacitor C2, an inductor L5 and a capacitor C3. An end of the capacitor C2 is connected to a positive electrode P of the three-level topology circuit, and the other end of the capacitor C2 is connected to a negative electrode N of the three-level topology circuit. An end of the inductor L5 is connected to a midpoint of each of the full-bridge arms, and the other end of the inductor L5 is connected to the motor. An end of the capacitor C3 is disposed between the motor and the inductor L5, and the other one end of the capacitor C3 is connected to the negative electrode N of the three-level topology circuit.

Further, each of the full-bridge arms is provided with a switch device T1, a switch device T2, a switch device T3 and a switch device T4 which are connected in series. A diode D5 is connected between a midpoint of the switch device T1 and the switch device T2 and a neutral point of the three-level topology circuit, and a diode D6 is connected between a midpoint of the switch device T3 and the switch device T4 and the neutral point of the three-level topology circuit.

Further, each of the full-bridge arms includes a main bridge arm and an auxiliary bridge arm. The main bridge arm is provided with a switch device T1 and a switch device T4 connected in series. The auxiliary bridge arm is provided with a switch device T2 and a switch device T3 connected in series. The main bridge arm and the auxiliary bridge arm are arranged in a T-type. An end of each of the auxiliary bridge arms is connected to a neutral point of the three-level topology circuit, and the other end of each of the auxiliary bridge arms is connected to a phase of the motor.

Further, both the switch device T1 and the switch device T4 are Si devices, and both the switch device T2 and the switch device T3 are SiC/GaN devices.

Further, both the switch device T1 and the switch device T4 are SiC/GaN devices, and both the switch device T2 and the switch device T3 are Si devices.

Further, midpoints of the first full-bridge arm, the second full-bridge arm and the third-full bridge arm are respectively connected to phase A, phase B and phase C of the motor.

Beneficial effects of the present invention are as follows: according to the present invention, each switch device of the three-level topology circuit is connected to the resonant soft switching circuit, and each resonant soft switching circuit is driven through a corresponding driving circuit. A spike pulse of each the switch device in the three-level topology circuit is absorbed or released by the resonant soft switching circuits through a common mode suppression method, and a buffering effect is played on the switch device simultaneously, so that characteristics of each switch device are more stable. A sudden change of the spike pulse is blocked by the inductor L1, the inductor L2 and the inductor L5, so that an anti-interference capability of the driving circuit is effectively enhanced, and meanwhile, switching loss of each of the switch devices may be balanced, thereby the switching loss of the switch device on each full-bridge arm may be reduced, and thus a service life of the switch device is prolonged.

Components in the resonant soft switching circuit constitute an energy absorbing and releasing circuit, which ensures that one of a voltage or a current borne by the switch device is maintained at a suitable value, and thereby the switching loss of the switch device and electromagnetic interference (EMI) noise is reduced.

Types of the switch device T1, the switch device T2, the switch device T3 and the switch device T4 on each full-bridge arm are specified, so that use cost of the switch device is effectively reduced, and meanwhile, a requirement of the switching loss to be achieved by each switch device of the three-level topology circuit is met.

A driving chip of the driving circuit and a switch device with a same type are matched for use, so that a level of driving and modulation of the three-level topology circuit is effectively improved, and an output efficiency of the topology circuit system is also effectively improved.

The inductor L1 and the inductor L2 play an effect of common-mode suppression, so that the energy that high dv/dt and di/dt of a load end of the motor reflected by stray inductance is suppressed, therefore stability of a gate voltage Vge of each of the switch devices is maintained, thereby electrical stress caused by the switch device is reduced, and thus the service life of the switching device is effectively prolonged.

### BRIEF DESCRIPTION OF THE DRAWINGS

In order to illustrate technical solutions of the present invention more clearly, the drawings required in the description embodiments or prior art will be briefly introduced below. Apparently, the drawings in the following description are merely some embodiments of the present invention, and for a person skilled in the art, other drawings may be obtained according to these drawings without creative work.
FIG. 1 is an overall circuit diagram of a topology circuit system having a Z-source three-level topology circuit, of a hybrid device-based driving motor according to an embodiment of the present invention.
FIG. 2 is a local circuit diagram of a topology circuit system of a hybrid device-based driving motor according to an embodiment of the present invention.
FIG. 3 is an overall circuit diagram of a topology circuit system having a Z-source three-level T-type topology circuit, of a hybrid device-based driving motor according to one embodiment of the present invention.

In the figures:
1- motor, 2- three-level topology circuit, 3- resonant soft switching circuit, 4- driving circuit, 5-filter circuit and 6- neutral point.

### DETAILED DESCRIPTION OF THE EMBODIMENTS

In the following, technical solutions in embodiments of the present invention will be clearly and completely described with reference to the drawings in the embodiments of the present invention. Apparently, the described embodiments are merely a portion rather than all of the embodiments of the present invention. All other embodiments obtained by a person skilled in the art based on the embodiments of the present invention without creative work shall fall within the protection scope of the present invention.

With the technical breakthrough of the third-generation SiC/GaN semiconductor devices, Si devices are gradually replaced by the SiC/GaN devices in the field of high-end drivers. The SiC/ GaN devices have characteristics of high switching frequency and low switching loss, which may significantly improve performance of a motor driver. Under the background of promoting carbon neutrality and peak carbon dioxide emissions, requirements for energy efficiency are becoming more and more stringent. An electrical topology structure for the high-end motor drivers gradually changes from a two-level structure to a multi-level structure, to improve driving efficiency of the motor. The manufacturing process of the SiC/GaN devices has a high difficulty, which leads to extremely expensive cost. More power devices are used in multi-level electrical topology, if all the power devices adopt the SiC/GaN device, design cost of the driver will be relatively high, which may seriously restrict large-scale commercial applications of the multi-level electrical topology. In the multi-level electrical topologies, requirements of each device are not consistent, so that loss of the power devices is not balanced. Therefore, it is urgent to invent a topology circuit system of a hybrid device-based driving motor.

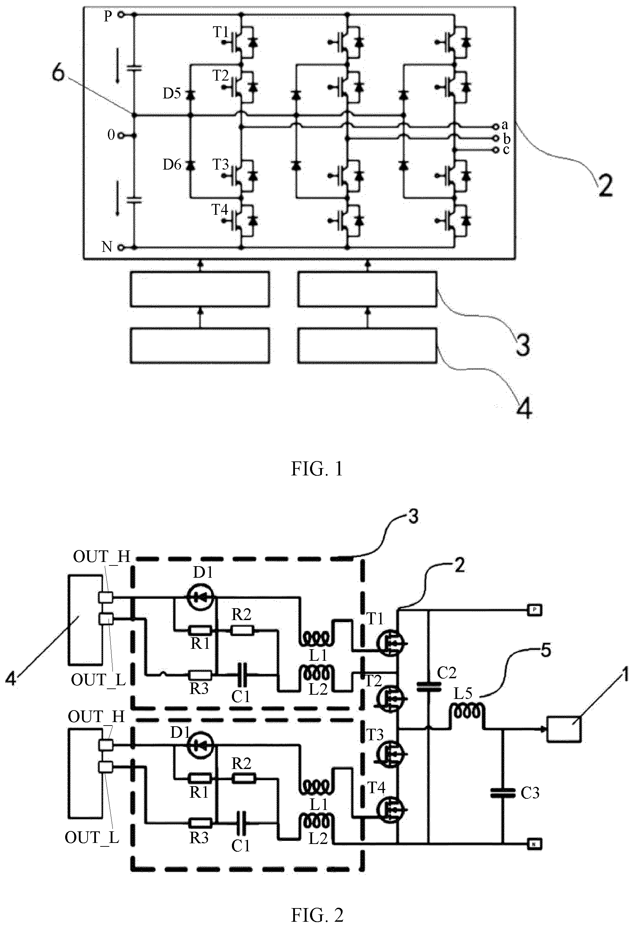

In a specific embodiment of the present invention, as shown in FIG. 1 to FIG. 3, the embodiment a topology circuit system of a hybrid device-based driving motor is specifically disclosed, which includes a motor 1, a three-level topology circuit 2 and driving circuits 4. The three-level topology circuit 2 includes a first full-bridge arm, a second full-bridge arm and a third full-bridge arm, each of the full-bridge arms is provided with a first switch device, a second switch device, a third switch device and a fourth switch device, and each of the switch devices is connected to resonant soft switching circuits 3. Two input ends of each of the resonant soft switching circuits 3 are connected to an output end OUT_H and an output end OUT_L of respective one in the driving circuits 4, respectively. A quantity of the driving circuits 4 is the same as a quantity of the resonant soft switching circuit 3. The driving circuits 4 and the resonant soft switching circuits 3 are disposed correspondingly to each other. A filter circuit 5 is disposed between the motor 1 and the three-level topology circuit 2.

Each of the resonant soft switching circuits 3 includes a diode D1, an inductor L1, a third resistor R3, a capacitor C1, an inductor L2, a first resistor R1 and a second resistor R2. The diode D1 and the inductor L1 are connected in series between the output end OUT_H of the driving circuit 4 and a gate of the switch device. The third resistor R3, the capacitor C1 and the inductor L2 are connected in series between the output end OUT_L of the driving circuit 4 and a source of the switch device. The first resistor R1 and the second resistor R2 are connected in series, and after connected in series, the other end of the first resistor R1 is connected to a negative electrode of the diode D1, and the other end of the second resistor R2 is disposed between the capacitor C1 and the inductor L2. A positive electrode of the diode D1 is connected to a node between the first resistor R1 and the second resistor R2, and the node between the first resistor R1 and the second resistor R2 is connected to a node between the third resistor R3 and the capacitor C1.

The filter circuit 5 includes a capacitor C2, an inductor L5 and a capacitor C3. An end of the capacitor C2 is connected to a positive electrode P of the three-level topology circuit 2, and the other end of the capacitor C2 is connected to a negative electrode N of the three-level topology circuit 2. An end of the inductor L5 is connected to a midpoint of each of the full-bridge arms, and the other end of the inductor L5 is connected to the motor 1. An end of the capacitor C3 is disposed between the motor 1 and the inductor L5, and the other end of the capacitor C3 is connected to a negative electrode N of the three-level topology circuit 2.

Each of the full-bridge arms is provided with a switch device T1, a switch device T2, a switch device T3 and a switch device T4 which are connected in series. A diode D5 is connected between a midpoint of the switch device T1 and the switch device T2 and a neutral point 6 of the three-level topology circuit 2, and a diode D6 is connected between a midpoint of the switch device T3 and the switch device T4 and the neutral point 6 of the three-level topology circuit 2.

Each of the full-bridge arms includes a main bridge arm and an auxiliary bridge arm. The main bridge arm is provided with a switch device T1 and a switch device T4 connected in series, and the auxiliary bridge arm is provided with a switch device T2 and a switch device T3 connected in series. The main bridge arm and the auxiliary bridge arm are arranged in a T-type, an end of each of the auxiliary bridge arms is connected to a neutral point of the three-level topology circuit 2, and the other end of each of the auxiliary bridge arms is connected to the motor 1.

A Si device is a silicon device, and a SiC/GaN device is a silicon carbide / gallium nitride device. In some examples, both the switch device T1 and the switch device T4 are Si devices, and both the switch device T2 and the switch device T3 are SiC/GaN devices.

In other examples, both the switch device T1 and the switch device T4 are SiC/GaN devices, and both the switch device T2 and the switch device T3 are Si devices.

Midpoints of the first full-bridge arm to the third-full bridge arm are respectively connected to phase A, phase B and phase C of the motor 1.

### Embodiment 1

A three-level topology circuit 2 includes three full-bridge arms, and the three full-bridge arms include a first full-bridge arm, a second full-bridge arm and a third full-bridge arm which are disposed from left to right. A midpoint of the first full-bridge arm is connected to phase A of a motor, a midpoint of the second full-bridge arm is connected to phase B of the motor, and a midpoint of the third-full bridge arm is connected to phase C of the motor. Each of the three full-bridge arms is provided with four switch devices, and the four switch devices are separately a switch device T1, a switch device T2, a switch device T3 and a switch device T4. Each of the switch devices is connected to resonant soft switching circuits 3;

There are three groups of driving circuits 4, each group of the driving circuits 4 includes four driving circuits, and each of the driving circuits is connected to the resonant soft switching circuits 3 in a one-to-one correspondence manner.

There are three groups of resonant soft switching circuits 3, each group of the resonant soft switching circuits 3 includes four resonant soft switching circuits, and each of the resonant soft switching circuits 3 includes a diode D1, a first resistor R1, a second resistor R2, a third resistor R3, a capacitor C1, an inductor L1, and an inductor L2. Each of the resonant soft switching circuits 3 includes a first main circuit, a second main circuit and a buffer circuit. The first main circuit includes the diode D1, the first resistor R1 and the inductor L1, an input end of the first main circuit is connected to an output end OUT_H of the driving circuit 4, and an output end of the first main circuit is connected to the switch device. The second main circuit includes the third resistor R3 and the inductor L1, an input end of the second main circuit is connected to an output end OUT_L of the driving circuit 4, and an output end of the second main circuit is connected to a source of the switch device. The first main circuit and the second main circuit are further provided with the second resistor R2 and the capacitor C1.

The main device of the buffer circuit is the inductor L2. The inductor L 2 is configured to suppress energy of a reflected wave output by a next-stage circuit, so that influence on the driving circuit 4 and the resonant soft switching circuit 3 is avoided.

A resonant frequency of the resonant soft switching circuit 3 is calculated according to a switching frequency of each of the switch devices and stray inductance existing in the circuit.

A direction of current of the switch device T1 is controlled by the driving circuit: the current output from the output end OUT_H of the driving circuit 4 passes through the first resistor R1 and is transported to a gate of the switch device T1 from the inductor L1, the reverse current between the gate and a source of the switch device T1 passes through the inductor L2 and is transported to an output end OUT_L of the driving circuit 4 from the third resistor R3. The inductor L2 has a buffering effect on the source of the switch device T1, so that the energy of reflected wave output by the next-stage circuit is suppressed.

The direction of current of the resonant soft switching circuit 3 of the switch device T2 and the switch device T3 on each of the full-bridge arms is the same as the direction of the current of the switch device T1. Stable current released by the switch device T4 is transported to a positive electrode P and a negative electrode N of the three-level topology circuit 2 through the capacitor C2. The pulse waveform modulated by the switch devices is filtered by the inductor L5 and the capacitor C3 on a filter circuit 5, and is transmitted to the phase A, the phase B and the phase C of the motor after being filtered.

Common mode suppression is mainly completed by the inductor L1 and the inductor L2, so that the energy that high dv/dt and di/dt of a load end of the motor reflected by stray inductance is suppressed, therefore stability of a gate voltage Vge of each of the switch devices is maintained, thereby electrical stress caused by the switch device is reduced, and thus service life of the switching device is effectively prolonged.

FIG. 1 is a presentation state of a three-level topology circuit 2 according to an embodiment of the present application. In the figure, each bridge arm is I-type. The switch device T1 and the switch device T4 on each bridge arm are Si devices, and the switch device T2 and the switch device T3 are SiC/GaN devices. A diode D5 is connected between a midpoint of the switch device T1 and the switch device T2 and a neutral point 6 of the three-level topology circuit 2, an end of the diode D5 is disposed on a node between the switch device T1 and the switch device T2 on each full-bridge arm, and the other end forms a neutral line with the neutral point 6 of the three-level topology circuit 2. A diode D6 is connected between a midpoint of the switch device T3 and the switch device T4 and the neutral point 6 of the three-level topology circuit 2, an end of the diode D6 is disposed at a node between the switch device T3 and the switch device T4 on each full-bridge arm, and the other end is disposed at a node where the diode D5 intersects with the neutral line. Both the diode D5 and the diode D6 are SiC/GaN devices, and a carrying current of the Si device is selected to be greater than or equal to a carrying current of the SiC/GaN device. Driving chips of the driving circuit 4 include a Si power converter driving chip and a SiC/GaN power converter driving chip. The Si power converter driving chip of the driving circuit 4 is correspondingly used for the Si devices of the switch device T1 and the switch device T4, and the SiC/GaN power converter driving chip of the driving circuit 4 is correspondingly used for the SiC/GaN devices of the switch device T2 and the switch device T3.

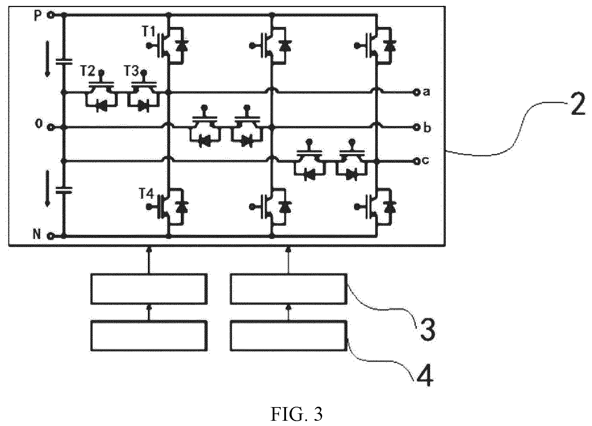

FIG. 3 is another presentation state of the three-level topology circuit 2 according to an embodiment of the present application. In the figure, both the switch device T1 and the switch device T4 on the main bridge arm are SiC/GaN devices, and both the switch device T2 and the switch device T3 on the auxiliary bridge arm are Si devices. A carrying current of the Si device is selected to be greater than or equal to a carrying current of the SiC/GaN device, and an operating voltage may preferably be half of an operating voltage of the SiC/GaN device. Driving chips of the driving circuit 4 include a Si power converter driving chip and a SiC/GaN power converter driving chip, the SiC/GaN power converter driving chip of the driving circuit 4 is correspondingly used for the SiC/GaN devices of the switch device T1 and the switch device T4, and the Si power converter driving chip of the driving circuit 4 is correspondingly used for the Si devices of the switch device T2 and switch device T3.

FIG. 2 merely shows directions of current of any two switch devices on each full-bridge arm in the three-level topology circuit 2 in FIG. 1.

By adjusting parameters of the resonant soft switching circuit 3, the equivalent switch rising edge and switch falling edge of different types of devices are realized.

The workflow of the present invention is as follows: a power supply input voltage or current to the three-level topology circuit 2, the driving circuit 4 and the resonant soft switching circuit 3 control the switching sequence of the switch devices on the three-level topology circuit 2, the pulse waveform modulated by the switch devices in the resonant soft switching circuit 3 is filtered by the inductor L5 and the capacitor C3 on the filter circuit 5, and is transmitted to the phase A, the phase B and the phase C of the motor after being filtered.

There are four resonant soft switching circuits 3 on each full-bridge arm, and the four resonant soft switching circuits 3 are respectively disposed in a one-to-one correspondence manner with the switch device T1, the switch device T2, the switch device T3 and the switch device T4. Two input ends of the resonant soft switching circuit 3 are connected to an output end OUT_H and an output end OUT_L of the driving circuit 4, respectively.

Driving chips of the driving circuit 4 are correspondingly selected for two types of the switch devices, namely the Si device and the SiC/GaN device. The current output from the output end OUT_L of the driving chip passes through the resonant soft switching circuit 3 to the source of the switch device T1. By a common mode suppression method, one of the voltage or the current borne by each switch device is maintained at a suitable value, so that switching loss of the switch device and EMI noise is reduced.

It should be noted that, in the present specification, relation terms such as first and second are merely used for distinguishing one entity or operation from another entity or operation without necessarily requiring or implying any such actual relationship or order between these entities or operations. Furthermore, the terms "include", "contain" or any other variation thereof are intended to cover a non-exclusive inclusion, such that a process, a method, an article or an apparatus that includes a series of elements includes not only those elements, but also other elements that are not explicitly listed, or elements inherent in the process, the method, the article or the apparatus. In the absence of more restrictions, elements defined by the sentence "include one..." does not preclude the existence of other identical elements in the process, the method, the article or the device that includes the element.

**In** the present invention, unless expressly specified and limited otherwise, terms such as "installed", "connected", "connection" and "fixed" shall be understood broadly, for example, it may be a fixed connection, a detachable connection or an integral connection; it may be a mechanical connection or an electrical connection; or it may be directly connected or may be indirectly connected by using an intermediate medium or may be a communication inside the two elements or an interaction relationship between two elements, unless expressly limited otherwise. For a person skilled in the art, the specific meanings of the above-mentioned terms in the present invention may be understood according to specific situations.

In the description of the present specification, the description referring to terms such as "one embodiment", "some embodiment", "an example", "a specific example" or "some examples" means that features, structures, materials or characteristics described in combination with this embodiment or example are included in at least one embodiment or example of the present invention. In the present specification, the schematic expression of the above-mentioned terms is not necessarily aimed at the same embodiment or example. Moreover, the specific features, structures, materials or characteristics described may be combined in any one or more embodiments or examples in a suitable manner. In addition, in a case without mutual contradictory, a person skilled in the art may combine and incorporate different embodiments or examples described in the present specification and features of different embodiments or examples.

What has been disclosed above is merely a preferred embodiment of the present invention, certainly, it cannot be used for limiting the scope of the present invention, and therefore, the equivalent changes made according to the claims of the present invention still fall within the scope of the present invention.

## Claims

1. A topology circuit system of a hybrid device-based driving motor, comprising:
a motor (1), a three-level topology circuit (2) and driving circuits (4),
wherein the three-level topology circuit (2) comprises a first full-bridge arm, a second full-bridge arm and a third full-bridge arm, each of the full-bridge arms is provided with a first switch device, a second switch device, a third switch device and a fourth switch device, each of the switch devices is connected to resonant soft switching circuits (3), two input ends of each of the resonant soft switching circuits (3) are connected to an output end OUT_H and an output end OUT_L of respective one in the driving circuits (4), respectively, a quantity of the driving circuits (4) is the same as a quantity of the resonant soft switching circuits (3), the driving circuits (4) and the resonant soft switching circuits (3) are disposed correspondingly to each other, and a filter circuit (5) is disposed between the motor (1) and the three-level topology circuit (2).

2. The topology circuit system of the hybrid device-based driving motor according to claim 1, wherein each of the resonant soft switching circuits (3) comprises a diode D1, an inductor L1, a third resistor R3, a capacitor C1, an inductor L2, a first resistor R1 and a second resistor R2, the diode D1 and the inductor L1 are connected in series between the output end OUT_H of the driving circuit (4) and a gate of the switch device, the third resistor R3, the capacitor C1 and the inductor L2 are connected in series between the output end OUT_L of the driving circuit (4) and a source of the switch device, the first resistor R1 and the second resistor R2 are connected in series, and after connected in series, the other end of the first resistor R1 is connected to a negative electrode of the diode D1, and the other end of the second resistor R2 is disposed between the capacitor C1 and the inductor L2, a positive electrode of the diode D1 is connected to a node between the first resistor R1 and the second resistor R2, and the node between the first resistor R1 and the second resistor R2 is connected to a node between the third resistor R3 and the capacitor C1.

3. The topology circuit system of the hybrid device-based driving motor according to claim 1, wherein the filter circuit (5) comprises a capacitor C2, an inductor L5 and a capacitor C3, an end of the capacitor C2 is connected to a positive electrode P of the three-level topology circuit (2), and the other end of the capacitor C2 is connected to a negative electrode N of the three-level topology circuit (2), an end of the inductor L5 is connected to a midpoint of each of the full-bridge arms, the other end of the inductor L5 is connected to the motor (1), and an end of the capacitor C3 is disposed between the motor (1) and the inductor L5, and the other end of the capacitor C3 is connected to a negative electrode N of the three-level topology circuit (2).

4. The topology circuit system of the hybrid device-based driving motor according to claim 1, wherein each of the full-bridge arms is provided with a switch device T1, a switch device T2, a switch device T3 and a switch device T4 which are connected in series, a diode D5 is connected between a midpoint of the switch device T1 and the switch device T2 and a neutral point (6) of the three-level topology circuit (2), and a diode D6 is connected between a midpoint of the switch device T3 and the switch device T4 and the neutral point (6) of the three-level topology circuit (2).

5. The topology circuit system of the hybrid device-based driving motor according to claim 1, wherein each of the full-bridge arms comprises a main bridge arm and an auxiliary bridge arm, the main bridge arm is provided with a switch device T1 and a switch device T4 connected in series, the auxiliary bridge arm is provided with a switch device T2 and a switch device T3 connected in series, the main bridge arm and the auxiliary bridge arm are arranged in a T-type, an end of each of the auxiliary bridge arms is connected to a neutral point of the three-level topology circuit (2), and the other end of each of the auxiliary bridge arms is connected to the motor (1).

6. The topology circuit system of the hybrid device-based driving motor according to claim 4, wherein both the switch device T1 and the switch device T4 are Si devices, and both the switch device T2 and the switch device T3 are SiC / GaN devices.

7. The topology circuit system of the hybrid device-based driving motor according to claim 5, wherein both the switch device T1 and the switch device T4 are SiC / GaN devices, and both the switch device T2 and the switch device T3 are Si devices.

8. The topology circuit system of the hybrid device-based driving motor according to claim 1, wherein midpoints of the first full-bridge arm, the second full-bridge arm and the third-full bridge arm are respectively connected to phase A, phase B and phase C of the motor (1).
